# EUROPÄISCHE PATENTSCHRIFT

(11) **EP 1 889 305 B1**
(45) Veröffentlichungstag und Bekanntmachung des Hinweises auf die Patenterteilung: **13.03.2013**
(21) Anmeldenummer: 06742403.6
(22) Anmeldetag: 09.06.2006
(51) Int. Cl.: H01L 41/083

(54) **PIEZOELEKTRISCHES VIELSCHICHTBAUELEMENT**
PIEZOELECTRIC MULTILAYER COMPONENT
COMPOSANT PIÉZOÉLECTRIQUE À PLUSIEURS COUCHES

(30) Priorität: 09.06.2005 DE 102005026717
(43) Veröffentlichungstag der Anmeldung: 20.02.2008
(60) Teilanmeldung: 10176613.7
(73) Patentinhaber: EPCOS AG, 81669 München (DE)
(72) Erfinder: FLORIAN, Heinz, A-8524 Bad Gams (AT); HIRSCHLER, Michael, A-8020 Graz (AT); SOMMARIVA, Helmut, A-8053 Graz (AT)
(74) Vertreter: Epping - Hermann - Fischer
(86) Internationale Anmeldenummer: PCT/DE2006/000992
(87) Internationale Veröffentlichungsnummer: WO 2006/131106

(56) Entgegenhaltungen:
- WO-A-98/05080
- WO-A-2004/077583
- WO-A-2006/079324
- DE-A1- 19 709 690
- GB-A- 2 375 884
- JP-A- 2007 012 867

## Beschreibung

Es wird ein piezoelektrisches Vielschichtbauelement angegeben mit übereinander liegenden keramischen Schichten und dazwischen liegenden Elektrodenschichten.

Es sind aus der Druckschrift DE 103 07 825 A1 Piezoaktoren bekannt, bei denen in einem Stapel übereinander liegende piezokeramische Schichten angeordnet sind.

Aus der Druckschrift WO 2004/077584 A1 geht ein piezoelektrisches Vielschichtbauelement hervor, bei dem zwischen zwei keramischen Schichten eine keramische Sollbruchschicht angeordnet ist.

Aus der Druckschrift WO 98/05080 A1 geht ein piezoelektrischer Wandler hervor, bei dem Zwischenräume im Bauelement mit einem Füllmaterial gefüllt sind.

Aus der Druckschrift GB 2 375 884 A geht ein gebogenes piezoelektrisches Bauelement hervor, das mit einer externen Schutzschicht versehen ist.

Eine zu lösende Aufgabe besteht darin, ein piezoelektrisches Vielschichtbauelement anzugeben, das besonders für den Einsatz in einem Kraftfahrzeug geeignet ist.

Diese Aufgabe wird gelöst durch ein piezoelektrisches Vielschichtbauelement nach Patentanspruch 1. Vorteilhafte Ausgestaltungen des Vielschichtbauelements sind den weiteren Patentansprüchen zu entnehmen.

Gemäß wenigstens einer Ausführungsform eines piezoelektrischen Bauelements wird ein Stapel von übereinander liegenden piezoelektrischen Schichten angegeben.

Zwischen piezoelektrischen Schichten können Elektrodenschichten angeordnet sein, die vorzugsweise die Funktion von Innenelektroden haben und die dem Aufbau eines elektrischen Feldes in den piezoelektrischen Schichten dienen.

Vorzugsweise ist jeweils zwischen zwei piezoelektrischen Schichten eine Elektrodenschicht angeordnet.

Erfindungsgemäß weist das Bauelement wenigstens eine Absorptionsschicht im Schichtstapel auf, die einen Grenzflächeneffekt für Druckwellen beziehungsweise Schallwellen oder mechanische Schwingungsimpulse erzeugt.

Mit einem Grenzflächeneffekt wird das Verhalten einer Welle verstanden, wenn sie von einem Medium erster Dichte in ein Medium zweiter Dichte eintritt. Dabei werden ihre Eigenschaften verändert, wie z.B. ihre Form und / oder ihre Propagationsart. Die Veränderung der Welleneigenschaften könnte durch eine Amplitudenveränderung, Ablenkung, Verzerrung oder Brechung gezeigt werden.

Der Grenzflächeneffekt kann dabei sowohl innerhalb der Absorptionsschicht entstehen, als auch an der Grenzfläche zwischen den Absorptionsschichten und den benachbarten Elektrodenschichten oder piezoelektrischen Schichten.

Mechanische Schwingungen treten in dem beschriebenen piezoelektrischen Bauelement beispielsweise dann auf, wenn das Bauelement in einem Kraftstoffeinspritzsystem eines Kraftfahrzeuges angewendet wird. In diesem Fall wirken je nach Konstruktion der Einspritzsysteme mechanische Kräfte auf das piezoelektrische Vielschichtbauelement ein. Die mechanischen Belastungen können sich beispielsweise aus dem Kraft-Weg-Diagramm unter Berücksichtigung der Dynamik des Einspritzvorganges ergeben. Wird die Ausdehnung des piezoelektrischen Vielschichtbauelements durch einen mechanischen Anschlag begrenzt, wie dies beispielsweise in Pumpe-Düse-Einspritzsystemen für Dieselmotoren der Fall ist, so treten besonders hohe mechanische Belastungen auf, gegen die das piezoelektrische Vielschichtbauelement geschützt werden muss, da die Gefahr der Beschädigung besteht. In ähnlicher Weise können die dynamischen Rückwirkungen des Einspritzsystems, beispielsweise beim Auftreffen schnell bewegter mechanischer Teile auf das piezoelektrische Vielschichtbauelement mechanische Schwingungen bzw. mechanische Belastungen des Bauelementes herbeiführen.

Die Verwendung eines hier angegebenen Bauelements mit einer Absorptionsschicht hat den Vorteil, dass wenigstens ein Teil der mechanischen Schwingungsenergie, beispielsweise der Aufprallenergie bzw. der Schlagenergie von der Absorptionsschicht absorbiert werden kann, so dass die Gefahr der mechanischen Beschädigung des Vielschichtbauelementes reduziert ist.

Vorzugsweise ist die Absorptionsschicht so gestaltet, dass sie die Möglichkeit der Dissipation bietet, d.h., dass die Schwingungsenergie bzw. die mechanische Energie in Wärme umgewandelt werden kann.

Der Grenzflächeneffekt in oder bei den Absorptionsschichten kann insbesondere zur Absorption, Brechung, Zerstreuung oder auch Ablenkung der mechanischen Energie führen. Die mechanische Energie kann dabei aus einer Druckwelle beziehungsweise aus einem mechanischen Schwingungsimpuls stammen und beispielsweise durch Aufprall-, Schlag-, Schall- oder Schwingungsenergie erzeugt worden sein.

Gemäß den hier beschriebenen Ausführungsformen ist es vor allem vorgesehen, dass mechanische Energie, die durch Schläge oder Vibrationen in das Bauelement eingebracht wird, an einer der Absorptionsschichten zerstreut, abgelenkt oder gedämpftwird. Insbesondere kann die Absorptionsschicht als Bereich mit veränderter Dichte und somit Elastizität beziehungsweise Komprimierbarkeit im Bauelement konzipiert sein. Dieser Bereich soll Druck- bzw. Schallwellen ablenken und Vibrationsenergie aufnehmen.

Beim Betrieb des hier beschriebenen Vielschichtbauelements ist die Entstehung eines Risses in den Absorptionsschichten nicht beabsichtigt. Falls doch ein Riss entsteht, so ist dies ein Riss, der eine möglichst große Länge hat und vollständig in der Absorptionsschicht verläuft, um dabei viel Energie aufzunehmen. Vorzugsweise entsteht ein Riss in Form einer Zick-Zack-Kurve mit möglichst vielen Richtungswechseln bezogen auf die Ausdehnung des Risses und mit einer möglichst großen Gesamtlänge in Bezug auf die radiale Ausdehnung des Schichtstapels. Auf einen glatten Riss in den Absorptionsschichten kommt es dabei nicht an.

Darüber hinaus hat die Absorptionsschicht den Vorteil, dass bei einer schnellen Abfolge mehrerer mechanischer Stöße auf das Vielschichtbauelement eine dauerhafte Ausbreitung der dadurch entstehenden mechanischen Stoßwellen, beispielsweise auch durch Reflexion an den äußeren Enden des Bauelements, wirksam vermindert werden kann. Hierfür wird die Absorptionsschicht so gestaltet, dass beispielsweise in Schallgeschwindigkeit durch das Bauelement laufende Stoßwellen an Grenzflächen zwischen einer Absorptionsschicht und einer piezoelektrischen Schicht bzw. an einer Grenzfläche zwischen einer Absorptionsschicht und einer Innenelektrodenschicht eine Beugung oder eine Brechung erfahren, wodurch die geradlinige Ausbreitung der Stoßwelle geschwächt wird. Dadurch können sich hochschaukelnde bzw. kumulierende, durch schnelle aufeinander folgende mechanische Stöße bewirkte Stoßwellenpakete hinsichtlich ihrer Intensität verringert und die Gefahr der Zerstörung des Bauelements vermindert werden.

Die Absorptionsschicht kann insbesondere eine keramische, beispielsweise eine piezoelektrische Schicht sein.

Vorzugsweise ist es vorgesehen, dass die Absorptionsschicht eine andere, bevorzugt eine geringere Dichte als die benachbarten piezoelektrischen Schichten aufweist. Dabei kann die Absorptionsschicht auch komprimierbare Bereiche enthalten, wobei diese Bereiche aus festen oder auch aus gasförmigen Materialien bestehen.

Erfindungsgemäß ist die Absorptionsschicht wesentlich dicker als die jeweiligen piezoelektrischen Schichten. Dies ist insbesondere dann vorteilhaft, wenn die Absorptionsschicht auf der Basis eines keramischen Materials gefertigt ist. Beispielsweise kann die Absorptionsschicht zwei bis dreimal dicker sein als die übrigen piezoelektrischen Schichten. Dadurch kann die Elastizität des gesamten Bauelementes erhöht und die Empfindlichkeit gegenüber Schlägen entsprechend reduziert werden.

Die Absorptionsschicht kann auch von Grund auf aus einem elastischen Material, z. B. einem Klebstoff gebildet sein. Nicht-erfindungsgemäß genügt in diesem Fall schon eine verglichen mit den piezoelektrischen Schichten dünne Absorptionsschicht, um die gesamte Elastizität des gesamten Stapels ausreichend zu erhöhen.

Vorzugsweise weist die Absorptionsschicht eine höhere Elastizität auf als ihre Umgebung und insbesondere als die piezoelektrischen Schichten.

Auch die Komprimierbarkeit der Absorptionsschicht ist gegenüber den übrigen Schichten des Schichtstapels vorzugsweise erhöht. Als Folge davon kann das Bauelement eine verringerte Steifigkeit aufweisen.

Vorzugsweise enthalten die Absorptionsschichten einen Stoff, der sich vom Grundmaterial der piezoelektrischen Schichten unterscheidet.

Gemäß einer Ausführungsform des Bauelements ist es vorgesehen, dass eine Absorptionsschicht eine keramische Schicht ist. Insbesondere kann es vorgesehen sein, dass auch die piezoelektrischen Schichten des Schichtstapels keramische
Schichten sind. In diesem Fall ist es vorteilhaft, wenn die Absorptionsschicht ihre geringere Dichte dadurch erhält, dass sie eine höhere Porosität aufweist, als die benachbarten piezoelektrischen keramischen Schichten.

Es ist vorgesehen, dass das Bauelement durch Gemeinsamsintern mehrerer übereinander liegender keramischer Grünfolien hergestellt wird. Durch einen solchen Sinterprozess kann beispielsweise ein monolithisches Bauelement entstehen.

Des weiteren ist es gemäß einer Ausführungsform des Bauelements vorgesehen, dass mehrere Absorptionsschichten über den Schichtstapel verteilt angeordnet werden. Für den Fall, dass als Absorptionsschicht ein Keramikmaterial verwendet wird, kann die Absorptionsschicht gemeinsam mit den übrigen piezoelektrischen keramischen Schichten gesintert werden. Dadurch entsteht eine besonders gute mechanische Anbindung der Absorptionsschicht an den Rest des Bauelementes, so dass die mechanische Belastbarkeit des Bauelementes verbessert wird.

Bei dem hier beschriebenen Bauelement kann insbesondere wenigstens eine Absorptionsschicht vorgesehen sein, die einen anorganischen Werkstoff enthält. Dieser anorganische Werkstoff sorgt für eine Komprimierbarkeit der Schicht. Insbesondere kann dieser Werkstoff durch seine Verteilung Grenzeffekte für Druckwellen verursachen, die die Druckwellen zerstreuen und brechen. Beispielsweise kann der anorganische Werkstoff ein Gas sein. Es kommt aber auch ein entsprechend verteilter kristalliner oder amorpher Festkörper ,in Betracht. Die Verteilung des anorganischen Stoffs kann vorzugsweise in Form von Partikeln vorliegen, die gleichmäßig über die Dicke und die laterale Ausdehnung der Schicht verteilt sind.

Gemäß einer Ausführungsform des Bauelementes ist eine Absorptionsschicht vorgesehen, die ein anorganisches Material enthält. Beispielsweise kann es sich dabei um ein Metall oder auch um einen keramischen Werkstoff handeln.

Darüber hinaus ist es gemäß einer Ausführungsform des Bauelements vorgesehen, dass die Absorptionsschicht organische Materialien enthält oder sogar vollständig aus organischen Materialien aufgebaut ist. Hierfür kommen beispielsweise Klebstoffe oder auch duroplastische Kunststoffe in Betracht.

Die organischen Bestandteile werden insbesondere so gewählt, dass sie entsprechend ihren Materialeigenschaften und entsprechend ihrer Verteilung in der Absorptionsschicht Schwingungsenergie aufnehmen und Druckwellen brechen oder zerstreuen. Die Verteilung der organischen Bestandteile wird vorzugsweise wie bei den anorganischen Bestandteilen gewählt.

In einer Ausführungsform des Bauelements wird die Absorptionsfähigkeit der Absorptionsschicht dadurch erreicht, dass sie gegenüber den keramischen Schichten eine höhere Porosität aufweisen.

Das Bauelement wird durch Sintern eines Stapels von übereinander liegenden keramischen Grünfolien und dazwischen liegenden Elektrodenschichten hergestellt. Dadurch entsteht ein monolithisches Bauelement, das einfach und billig herzustellen ist und das für die weiteren Bearbeitungsschritte eine ausreichende mechanische Stabilität besitzt.

Um die Absorptionsfähigkeit des Bauelements bezüglich mechanischer Schwingungen weiter zu verbessern, kann es vorgesehen sein, dass an mehreren Stellen der Längsachse Absorptionsschichten vorgesehen sind. Dadurch wird gewissermaßen das Bauelement entlang der Längsachse in mehrere Teil-Bauelemente unterteilt.

Poröse Schichten in einem keramischen Vielschichtbauelement stellen eine Diskontinuität für Druckwellen dar. Ferner können an den Poren von außen Flüssigkeiten oder Gase in das Bauelement eindringen. Es ist daher vorteilhaft, wenn die porösen Schichten beim Betrieb des Bauelements weitgehend frei von elektrischen Feldern gehalten werden, um unerwünschte Migrationseffekte zu vermeiden. Dies wird dadurch erreicht, dass die beiden unmittelbar zu einer Absorptionsschicht benachbarten Elektrodenschichten demselben elektrischen Pol des Bauelements zugeordnet sind. Dann können keine nennenswerten elektrischen Felder mehr über die Absorptionsschicht aufgebaut werden.

In einer Ausführungsform des Bauelements ist die Porosität der Absorptionsschicht gegenüber den keramischen Schichten um einen Faktor zwischen 1,2 und 3 erhöht. Diese Angabe der Porosität bezieht sich auf die folgende Methode zur Messung der Porosität:

Es wird das Bauelement in einem Längsschliff betrachtet. Poren, die sowohl in den keramischen Schichten als auch in den Absorptionsschichten auftreten können, unterscheiden sich durch einen farblichen bzw. Hell-Dunkel-Kontrast von dem sie umgebenden Keramikmaterial. Nun wird für jede Art von Schicht, also für die keramische Schicht und für eine Absorptionsschicht über eine Einheitsfläche der Flächenanteil der Poren an dieser Einheitsfläche ermittelt. Der Quotient aus den beiden Flächenanteilen der Poren ergibt den.Faktor der erhöhten Porosität.

Die Porosität kann auch als Bruchteil der theoretisch möglichen Dichte angegeben werden. In diesem Fall hätten die keramischen Schichten eine Dichte von ca. 97-98 % der theoretischen Dichte und die Absorptionsschichten eine Dichte von 90-95 % der theoretische Dichte.

Es ist des weiteren vorteilhaft, wenn die Absorptionsschicht aus demselben Keramikmaterial besteht, wie die piezoelektrischen keramischen Schichten. Dadurch kann die Materialvielfalt des Bauelements in vorteilhafter Weise reduziert werden, was zudem noch den positiven Nebeneffekt hat, dass die weiteren Prozesse zur Herstellung des Bauelements, wie beispielsweise Entbindern und Sintern, einfacher durchführbar sind.

Es ist darüber hinaus besonders vorteilhaft, wenn das elektrische Vielschichtbauelement ein piezoelektrischer Aktor ist, der in Kraftfahrzeugen eingesetzt werden kann.

Der hier angegebene Schichtstapel hat den Vorteil, dass durch einen erhöhten Volumenanteil an Bindemittel in einer oder mehrerer der Grünfolien in dem Schichtstapel die Herstellung von keramischen Schichten mit einer erhöhten Porosität möglich ist. Das Bindemittel wird nämlich noch vor dem Sintern durch einen Entkohlungsprozeß entfernt, wobei sich an den Stellen in den Schichten, in denen der hohe Anteil von Bindemittel vorhanden war, anschließend Poren bilden können.

Dabei ist es besonders vorteilhaft, wenn der Volumenanteil an Bindemittel um einen Faktor zwischen 1,5 und 3 erhöht ist. Dadurch kann die Gefahr vermindert werden, dass in der Keramikschicht zu wenig Keramikpulver vorhanden ist, so dass nach dem Sintern kein monolithisches Bauelement, sondern ein bereits vor dem elektrischen Betrieb in einzelne Teil-Bauelemente unterteiltes Bauelement resultiert.

Insbesondere kann mit Hilfe der hier beschriebenen Maßnahmen eine Absorptionsschicht bereitgestellt werden, die eine höhere Elastizität als die benachbarten Schichten aufweist, wodurch die Absorption von Druckwellen verbessert werden kann. Darüber hinaus wird durch die Anordnung der Absorptionsschichten im Vielschichtbauelement die Komprimierbarkeit des Bauelements verbessert und damit die Steifigkeit verringert.

Im folgenden wird ein Bauelement anhand eines Ausführungsbeispiels und den dazugehörigen Figuren näher erläutert.
- Figur 1: zeigt beispielhaft ein Vielschichtbauelement in einer perspektivischen Ansicht.
- Figur 2: zeigt einen Längsschnitt eines Teilbereichs des Bauelements aus Figur 1.

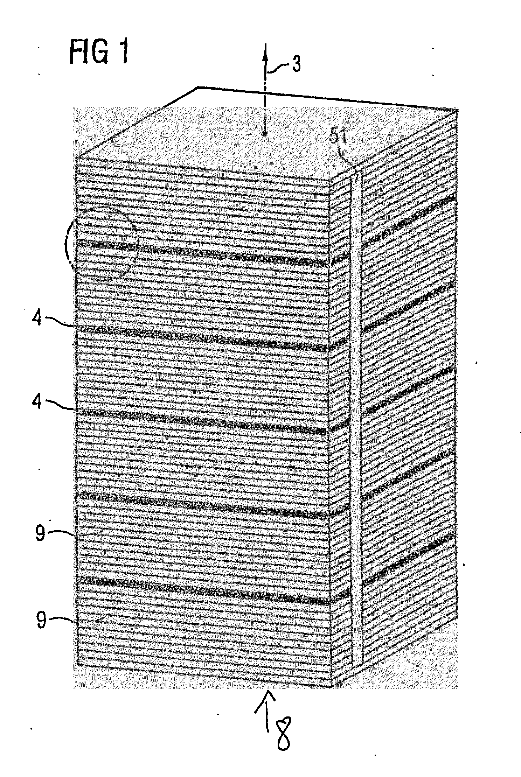

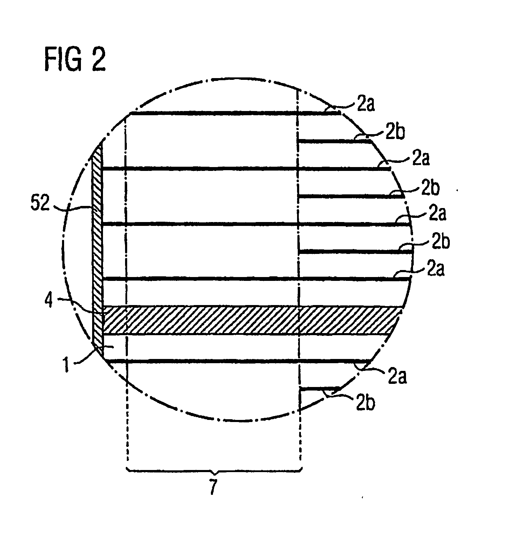

Die Figuren 1 und 2 zeigen einen piezoelektrischen Aktor, bei dem eine Vielzahl von keramischen Schichten 1 entlang einer Längsachse 3 übereinander gestapelt sind. Als Keramikmaterial für die keramischen Schichten 1 kann insbesondere eine PZT-Keramik, beispielsweise der Zusammensetzung Pb_{0,96}Cu_{0,02}Nd_{0,02}(Zr_{0,54}Ti_{0,46})O₃ verwendet werden.

Daneben sind Elektrodenschichten 2a, 2b vorgesehen, die jeweils zwischen zwei benachbarten keramischen Schichten 1 angeordnet sind. Dabei gehören die Elektrodenschichten 2a zu einem elektrischen Pol des Bauelements und die Elektrodenschichten 2b zum anderen Pol des elektrischen Bauelements. Die bis ganz an den rechten Rand des Bauelements herangeführten Elektrodenschichten 2b sind durch die Außenkontaktierung 51 miteinander elektrisch leitend verbunden und gleichzeitig ermöglicht die Außenkontaktierung 51 das Anlegen eines Pols einer elektrischen Spannungsquelle.

Dementsprechend sind die auf der linken Seite des Bauelements bis an den äußeren Rand reichenden Elektrodenschichten 2b mit einer auf der linken Seite des Bauelements (nicht in Figur 1 sichtbar) angeordneten Außenkontaktierung 52 elektrisch leitend verbunden. An die Außenkontaktierung 52 kann der andere Pol der elektrischen Spannungsquelle angeschlossen werden.

Im Gebiet einer passiven Zone 7 überlappen die Elektrodenschichten 2a und 2b einander nicht, sondern es sind lediglich Elektrodenschichten einer einzigen Sorte, beispielsweise Elektrodenschichten 2a (vgl. Figur 2) in der passiven Zone 7 vorhanden. Um einen von außen auftretenden Stoß 8 in Bezug auf seine Zerstörwirkung auf das Bauelement zu schwächen, sind Absorptionsschichten 4 vorgesehen.

Um die Absorptionsschicht 4 möglichst feldfrei auch bei Betrieb des Piezoaktors zu halten, ist es vorgesehen, wie in Figur 2 dargestellt, die unmittelbar zur Absorptionsschicht 4 benachbarten Elektrodenschichten 2a ein und demselben elektrischen Pol des Piezoaktors zuzuordnen.

Die Verteilung der Absorptionsschichten 4 entlang der Längsachse 3 ist dabei so vorzunehmen, dass Teilaktoren 9 entstehen, deren Höhe so stark reduziert ist, dass die bei dem normalen Betrieb des Piezoaktors auftretende mechanische Schwingungen keine Zerstörungen mehr in dem Aktor erzeugen können.

Beispielsweise kann es bei einem 30 mm hohen Piezoaktor vorgesehen sein, diesen durch neun Absorptionsschichten 4 in zehn Teilaktoren 9 zu unterteilen, wobei jeder Teilaktor 9 eine Höhe von 3 mm aufweist. Diese Höhe von 3 mm entspricht in einem Ausführungsbeispiel des Aktors einer Anzahl von 37 keramischen Schichten 1.

Im Fall von im wesentlichen keramischen Absorptionsschichten können diese eine Dicke bis 300 µm aufweisen, bei 120 µm dicken piezoelektrischen Schichten.

Als Material der Elektrodenschichten 2a, 2b kommt beispielsweise eine Mischung aus Silber und Palladium, wie sie zur Gemeinsamsinterung mit piezoaktiven Keramikschichten geeignet ist, in Betracht. Darüber hinaus kommen aber auch Elektrodenschichten 2a, 2b in Betracht, welche Kupfer enthalten oder sogar ganz aus Kupfer bestehen.

Die Herstellung des in den Figuren 1 und 2 dargestellten Piezoaktors kann mittels eines Schichtstapels erfolgen, dessen Aussehen dem in den Figuren 1 und 2 dargestellten Bauelement im wesentlichen gleicht, wobei jedoch noch keine Außenkontaktierungen 51, 52 vorhanden sind. Im übrigen entspricht der Aufbau der keramischen Schichten, der Elektrodenschichten und der Absorptionsschicht dem Aufbau eines Schichtstapels, wobei die keramischen Schichten in einer Vorform als keramische Grünfolien enthaltend ein Keramikpulver und einen organischen Binder ausgeführt sind. Die Elektrodenschichten sind als metallpulverhaltige Pasten ausgeführt. Die Absorptionsschichten sind wie die keramischen Schichten als Grünfolien ausgeführt, wobei jedoch der Anteil an organischem Binder in den später zu den Absorptionsschichten zu verarbeitenden Schichten gegenüber den übrigen keramischen Schichten erhöht ist. Beispielsweise können für die keramischen Schichten Grünfolien verwendet werden, bei denen ein Volumenanteil von 30 % von dem organischen Binder beansprucht wird. Um den Volumenanteil in bestimmten Schichten des Schichtstapels zu erhöhen, kann dieser auf einen Volumenanteil von 50 bis 60 % erhöht werden. Bei einem solchen Volumenanteil an organischem Binder können Probleme vermieden werden im Hinblick darauf, dass das Keramikpulver agglomeriert und keine definierten Folien mehr gezogen werden können.

Das Bauelement wird durch gemeinsames Sintern der in dem Schichtstapel befindlichen Schichten hergestellt. Dies geschieht vorzugsweise in einem einzigen Prozessschritt.

Es wird darauf hingewiesen, dass das vorstehend beschriebene elektrische Vielschichtbauelement nicht auf das genannte Keramikmaterial beschränkt ist. Es kommen vielmehr alle möglichen Keramikmaterialien in Betracht, die einen piezoelektrischen Effekt zeigen. Darüber hinaus ist das Bauelement auch nicht auf Piezoaktoren beschränkt. Es kommen vielmehr alle möglichen Piezokeramik materialien in Betracht, die eine elektrische Funktion ausüben. Insbesondere kann das Bauelement immer dort Verwendung finden, wo es mechanischen Belastungen, insbesondere Stoßbelastungen, ausgesetzt ist.

### Bezugszeichenliste

- 1: piezoelektrische Schicht
- 2a, b: Elektrodenschicht
- 3: Längsachse
- 4: Absorptionsschicht
- 51, 52: Außenkontaktierung
- 7: passive Zone
- 8: Stoßbelastung
- 9: Teilaktor

## Patentansprüche

1. Piezoelektrisches Vielschichtbauelement,
- mit einer Vielzahl von übereinander liegenden piezoelektrischen Schichten (1) und dazwischen angeordneten Elektrodenschichten (2a, 2b), die entlang einer Längsachse (3) zu einem Schichtstapel angeordnet und miteinander versintert sind,
- wobei im Schichtstapel wenigstens eine Absorptionsschicht (4) vorhanden ist, die für Druckwellen oder Schwingungsimpulse einen Grenzflächeneffekt bewirkt und
- wobei die Absorptionsschicht (4) wesentlich dicker ist als die jeweiligen piezoelektrischen Schichten (1).

2. Bauelement nach dem vorhergehenden Anspruch,
bei dem die Absorptionsschicht (4) eine piezoelektrische Schicht ist.

3. Bauelement nach einem der vorhergehenden Ansprüche,
bei dem die Absorptionsschicht (4) eine geringere Dichte als die benachbarten piezoelektrischen Schichten (1) aufweist.

4. Bauelement nach einem der vorhergehenden Ansprüche,
bei dem die Absorptionsschicht (4) komprimierbare Bereiche aus festen oder gasförmigen Bestandteilen enthält.

5. Bauelement nach einem der vorhergehenden Ansprüche,
bei dem die Absorptionsschicht (4) eine höhere Porosität aufweist als die benachbarten piezoelektrischen Schichten (1).

6. Bauelement nach einem der vorhergehenden Ansprüche, das mehrere Absorptionsschichten (4) aufweist.

7. Bauelement nach einem der vorhergehenden Ansprüche,
bei dem wenigstens eine Absorptionsschicht (4) einen anorganischen Werkstoff enthält.

8. Bauelement nach einem der vorhergehenden Ansprüche,
bei dem wenigstens eine Absorptionsschicht (4) ein Metall oder eine Keramik enthält.

9. Bauelement nach einem der vorhergehenden Ansprüche,
bei dem die zu einer Absorptionsschicht (4) unmittelbar benachbarten Elektrodenschichten (2a, 2b) demselben elektrischen Pol des Bauelements zugeordnet sind.

10. Bauelement nach einem der vorhergehenden Ansprüche,
bei dem wenigstens eine Absorptionsschicht (4) dasselbe Keramikmaterial enthält wie die piezoelektrischen Schichten (1).

11. Bauelement nach einem der vorhergehenden Ansprüche,
bei dem die Absorptionsschicht (4) gegenüber ihrer Umgebung eine erhöhte Komprimierbarkeit aufweist.

12. Bauelement nach einem der vorhergehenden Ansprüche,
wobei die Absorptionsschicht (4) einen Stoff enthält, der sich vom Grundmaterial der piezoelektrischen Schichten unterscheidet.

13. Bauelement nach einem der vorhergehenden Ansprüche,
wobei die Absorptionsschicht (4) zwei bis dreimal dicker ist als die jeweiligen piezoelektrischen Schichten (1).

14. Verwendung von Absorptionsschichten (4) nach einem der vorhergehenden Ansprüche in einem piezoelektrischen Vielschichtbauelement zur mechanischen Entlastung des Vielschichtbauelements durch Zerstreuung, Ablenkung oder Dämpfung mechanischer Schwingungsenergie.

## Claims

1. Piezoelectric multilayer component
- having a plurality of superposed piezoelectric layers (1) and electrode layers (2a, 2b) which are arranged in between along a longitudinal axis (3) to form a stack and are sintered to one another,
- wherein at least one absorption layer (4) which brings about an interfacial effect for pressure waves or vibrational impulses is present in the stack and
- wherein the absorption layer (4) is substantially thicker than the respective piezoelectric layers (1).

2. Component according to the preceding claim, wherein the absorption layer (4) is a piezoelectric layer.

3. Component according to any of the preceding claims,
wherein the absorption layer (4) has a lower density than the adjacent piezoelectric layers (1).

4. Component according to any of the preceding claims,
wherein the absorption layer (4) contains compressible regions composed of solid or gaseous constituents.

5. Component according to any of the preceding claims,
wherein the absorption layer (4) has a higher porosity than the adjacent piezoelectric layers (1).

6. Component according to any of the preceding claims which has a plurality of absorption layers (4).

7. Component according to any of the preceding claims,
wherein at least one absorption layer (4) contains an inorganic material.

8. Component according to any of the preceding claims, wherein at least one absorption layer (4) contains a metal or a ceramic.

9. Component according to any of the preceding claims, wherein the electrode layers (2a, 2b) directly adjacent to an absorption layer (4) are assigned to the same electrical pole of the component.

10. Component according to any of the preceding claims, wherein at least one absorption layer (4) contains the same ceramic material as the piezoelectric layers (1).

11. Component according to any of the preceding claims, wherein the absorption layer (4) has an increased compressibility compared to its surrounding.

12. Component according to any of the preceding claims, wherein the absorption layer (4) contains a material which differs from the base material of the piezoelectric layers.

13. Component according to any of the preceding claims, wherein the absorption layer (4) is from two to three times as thick as the respective piezoelectric layers (1).

14. Use of absorption layers (4) according to any of the preceding claims in a piezoelectric multilayer component for decreasing the mechanical stress on the multilayer component by scattering, deflection or damping of mechanical vibrational energy.

## Revendications

1. Composant à plusieurs couches piézoélectrique,
- comprenant une pluralité de couches piézoélectriques (1) déposées les unes au-dessus des autres et des couches d'électrode (2a, 2b) disposées entre elles, lesquelles sont disposées en une pile de couches le long d'un axe longitudinal (3) et sont agglomérées entre elles par frittage,
- au moins une couche d'absorption (4) étant présente dans la pile de couches, laquelle réalise un effet de surface limite pour les ondes de pression ou les impulsions oscillatoires et
- la couche d'absorption (4) étant considérablement plus épaisse que les couches piézoélectriques (1) respectives.

2. Composant selon la revendication précédente, dans lequel la couche d'absorption (4) est une couche piézoélectrique.

3. Composant selon l'une des revendications précédentes, dans lequel la couche d'absorption (4) présente une densité plus faible que les couches piézoélectriques (1) voisines.

4. Composant selon l'une des revendications précédentes, dans lequel la couche d'absorption (4) contient des zones compressibles en composantes solides ou gazeuses.

5. Composant selon l'une des revendications précédentes, dans lequel la couche d'absorption (4) présente une porosité plus élevée que les couches piézoélectriques (1) voisines.

6. Composant selon l'une des revendications précédentes, lequel présente plusieurs couches d'absorption (4).

7. Composant selon l'une des revendications précédentes, dans lequel au moins une couche d'absorption (4) contient un matériau inorganique.

8. Composant selon l'une des revendications précédentes, dans lequel au moins une couche d'absorption (4) contient un métal ou une céramique.

9. Composant selon l'une des revendications précédentes, dans lequel les couches d'électrode (2a, 2b) directement voisines d'une couche d'absorption (4) sont associées au même pôle électrique du composant.

10. Composant selon l'une des revendications précédentes, dans lequel au moins une couche d'absorption (4) contient le même matériau céramique que les couches piézoélectriques (1).

11. Composant selon l'une des revendications précédentes, dans lequel la couche d'absorption (4) présente une compressibilité accrue par rapport à son environnement.

12. Composant selon l'une des revendications précédentes, dans lequel la couche d'absorption (4) contient un matériau qui se différencie du matériau de base des couches piézoélectriques.

13. Composant selon l'une des revendications précédentes, dans lequel la couche d'absorption (4) est deux à trois fois plus épaisse que les couches piézoélectriques (1) respectives.

14. Utilisation de couches d'absorption (4) selon l'une des revendications précédentes dans un composant à plusieurs couches piézoélectrique pour le soulagement mécanique du composant à plusieurs couches par dispersion, déviation ou atténuation de l'énergie oscillatoire mécanique.
